# FASCICULE DE BREVET EUROPEEN

(11) **EP 3 615 950 B1**
(45) Date de publication et mention de la délivrance du brevet: **25.10.2023**
(21) Numéro de dépôt: 18717377.8
(22) Date de dépôt: 16.04.2018
(51) Int. Cl.: G01R 19/25, G01R 31/50, G01R 21/133

(54) **PROCEDE DE DETECTION D'UN AFFAISSEMENT D'UNE TENSION DE PHASE D'UN RESEAU ELECTRIQUE**
VERFAHREN ZUM ERKENNEN EINES ABFALLS EINER PHASENSPANNUNG EINES ELEKTRISCHEN NETZES
METHOD FOR DETECTING A SAG IN A PHASE VOLTAGE OF AN ELECTRICAL NETWORK

(30) Priorité: 26.04.2017 FR 1753646
(43) Date de publication de la demande: 04.03.2020
(73) Titulaire: Sagemcom Energy & Telecom SAS, 92500 Rueil-Malmaison (FR)
(72) Inventeur: TEBOULLE, Henri, 92500 Rueil Malmaison (FR)
(74) Mandataire: Lavaud, Thomas
(86) Numéro de dépôt international: PCT/EP2018/059696
(87) Numéro de publication internationale: WO 2018/197252

(56) Documents cités:
- EP-A1- 1 193 854
- EP-A1- 2 448 087
- EP-A2- 1 187 293
- CN-A- 102 623 269
- FR-A1- 2 585 158
- FR-A1- 2 749 084
- US-A1- 2012 033 338
- US-A1- 2015 077 891
- US-A1- 2015 276 830

## Description

L'invention concerne la gestion des réseaux électriques et plus particulièrement le domaine des procédés de détection d'un affaissement d'une tension de phase d'un réseau électrique.

### ARRIERE PLAN DE L'INVENTION

De nombreuses raisons peuvent conduire à un affaissement d'une tension d'un réseau électrique qui distribue de l'énergie électrique à des installations électriques.

Parmi ces raisons, on peut citer une consommation électrique trop importante des installations électriques. On peut aussi citer l'arrêt d'une unité de production électrique, telle qu'une centrale hydroélectrique ou une centrale nucléaire, dû à des opérations de maintenance, à une panne quelconque, ou à des conditions météorologiques défavorables.

La tension du réseau électrique ne s'affaisse pas nécessairement de manière homogène sur le réseau électrique. Généralement, les installations électriques qui sont les plus éloignées des unités de production fonctionnelles sont les plus touchées.

L'affaissement de la tension peut avoir des conséquences relativement importantes, aussi bien au niveau d'une installation électrique (dégradation du fonctionnement de l'installation électrique, panne) qu'au niveau du réseau électrique lui-même (écroulement de tension dû à des mises à l'arrêt en cascade de plusieurs unités de production électrique).

Un affaissement de la tension du réseau électrique peut être détecté au niveau d'un compteur électrique qui mesure l'énergie électrique fournie à une installation électrique par le réseau électrique.

Il convient cependant de s'assurer que l'affaissement de tension détecté par le compteur électrique ne provient pas du compteur électrique lui-même. Le compteur électrique peut en effet provoquer lui-même une chute de tension locale. Parmi les causes liées au compteur et pouvant provoquer une chute de tension locale, on trouve le « charbonnage » d'un organe de coupure du compteur. Certains compteurs comportent un organe de coupure qui permet de sélectivement connecter et déconnecter, à distance, l'installation électrique et le réseau électrique. Les contacts de l'organe de coupure sont susceptibles d'être soumis à des arcs électriques qui produisent des dépôts de carbone sur les contacts de l'organe de coupure. Le charbonnage désigne ce phénomène. Le charbonnage tend à augmenter la résistance de l'organe de coupure lorsque celui-ci est fermé. L'ordre de grandeur de l'augmentation typique de la résistance de l'organe de coupure est le mΩ. Or, le courant qui circule dans l'organe de coupure peut être très important, et peut atteindre typiquement la valeur de 140A. Ainsi, l'augmentation de la résistance de l'organe de coupure peut faire chuter la tension au niveau du compteur électrique de manière relativement importante. Les documents US 2015/077891 A1, CN 102 623 269 A et FR 2 585 158 A1 divulguent des procédés et les dispositifs associés de détection de défaut survenant sur un réseau électrique,

### OBJET DE L'INVENTION

L'invention a pour objet de détecter, au niveau d'un compteur électrique, un affaissement d'une tension de phase d'un réseau électrique, tout en assurant que l'affaissement ne provient pas du compteur électrique lui-même.

### RESUME DE L'INVENTION

En vue de la réalisation de ce but, on propose un procédé de détection d'un affaissement d'une tension de phase présente sur une phase d'un réseau électrique, le procédé de détection étant mis en oeuvre par un compteur électrique qui est connecté au réseau électrique et qui comporte un organe de coupure monté sur un conducteur de phase relié à la phase, le procédé de détection comprenant les étapes :
- de mesurer, en amont de l'organe de coupure et à intervalles réguliers, la tension de phase et un courant de phase circulant sur le conducteur de phase ;
- lorsque la tension de phase devient inférieure à un seuil de tension prédéterminé, d'ouvrir l'organe de coupure ;
- suite à l'ouverture de l'organe de coupure, si la tension de phase reprend une valeur de tension normale définie en fonction du courant de phase, de détecter un dysfonctionnement du compteur électrique, de générer un message d'alarme pour prévenir du dysfonctionnement du compteur électrique, et de maintenir ouvert l'organe de coupure ;
- suite à l'ouverture de l'organe de coupure, si la tension de phase demeure inférieure au seuil de tension prédéterminé, de détecter un affaissement de la tension de phase, de générer un message d'alerte pour prévenir de l'affaissement de la tension de phase, et de refermer l'organe de coupure.

Le procédé de détection permet donc à la fois de détecter un affaissement de la tension de phase, mais aussi d'assurer que l'affaissement de la tension de phase détecté provient bien du réseau électrique et non d'un dysfonctionnement du compteur électrique lui-même.

On propose de plus un compteur électrique comportant un organe de coupure, un capteur de tension, un capteur de courant, une mémoire et un composant de traitement agencé pour mettre en œuvre le procédé de détection qui vient d'être décrit.

On propose aussi un programme d'ordinateur comprenant des instructions pour mettre en oeuvre, par un compteur électrique, le procédé de détection qui vient d'être décrit.

On propose en outre des moyens de stockage, caractérisés en ce qu'ils stockent un programme d'ordinateur comprenant des instructions pour mettre en oeuvre, par un compteur électrique, le procédé de détection qui vient d'être décrit.

D'autres caractéristiques et avantages de l'invention ressortiront à la lecture de la description qui suit de modes de réalisation particuliers non limitatifs de l'invention.

### BREVE DESCRIPTION DES DESSINS

Il sera fait référence aux dessins annexés, parmi lesquels :
- la figure 1 représente un compteur électrique monophasé dans lequel est mis en oeuvre le procédé de détection selon un premier mode de réalisation de l'invention ;
- la figure 2 est un graphique sur lequel sont représentés des points de référence, une courbe de bornes supérieures d'intervalles de référence, une courbe de bornes inférieures des intervalles de référence, et un nouveau point ;
- la figure 3 représente un compteur électrique triphasé dans lequel est mis en oeuvre le procédé de détection selon un deuxième mode de réalisation de l'invention.

### DESCRIPTION DETAILLEE DE L'INVENTION

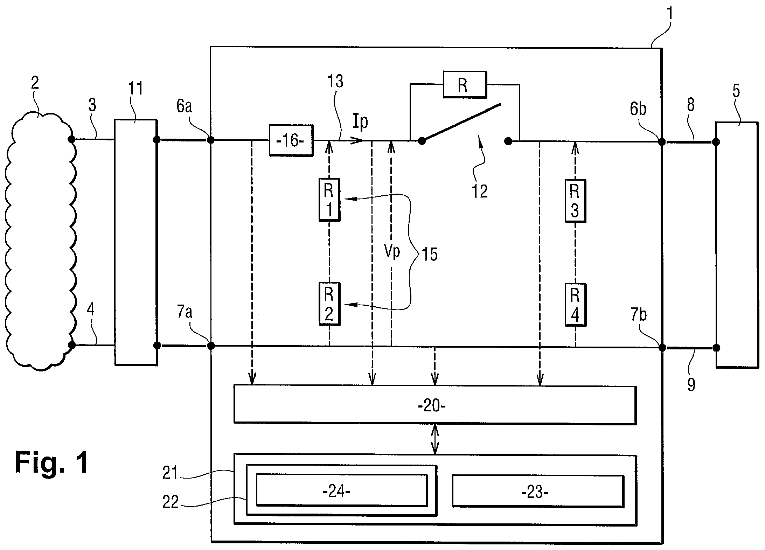

En référence à la figure 1, le procédé de détection d'un affaissement d'une tension de phase d'un réseau électrique selon un premier mode de réalisation de l'invention est ici mis en oeuvre par un compteur électrique monophasé 1.

Le réseau électrique 2 est un réseau électrique monophasé, qui comporte une phase 3 et un neutre 4.

Le compteur 1 est destiné à mesurer une consommation d'énergie électrique fournie par le réseau électrique 2 à une installation électrique 5.

Le compteur 1 comporte une borne de phase amont 6a, une borne de phase aval 6b, une borne de neutre amont 7a et une borne de neutre aval 7b.

La borne de phase amont 6a est connectée à la phase 3 du réseau électrique 2. La borne de phase aval 6b est connectée à une phase 8 de l'installation électrique 5. La borne de neutre amont 7a est connectée au neutre 4 du réseau électrique 2. La borne de neutre aval 7b est connectée à un neutre 9 de l'installation électrique 5.

Un sectionneur 11 est positionné du côté du réseau électrique 2, pour pouvoir isoler du réseau électrique 2 l'installation électrique 5 lorsque cela est nécessaire.

Le compteur 1 comporte de plus un organe de coupure 12 monté sur un conducteur de phase 13 du compteur 1. Le conducteur de phase 13 est relié à la phase 3 du réseau électrique 2 lorsque le compteur 1 est raccordé au réseau électrique 2. L'organe de coupure 12 est monté entre la borne de phase amont 6a et la borne de phase aval 6b.

L'organe de coupure 12 permet de sélectivement connecter et déconnecter, à distance, l'installation électrique 5 du réseau électrique 2.

Le compteur 1 comporte de plus un capteur de tension de phase 15 et un capteur de courant de phase 16.

Le capteur de tension de phase 15 est symbolisé par deux résistances, mais il est en réalité possiblement plus complexe.

Le capteur de courant de phase 16 est ici un *shunt.*

Le capteur de tension de phase 15 et le capteur de courant de phase 16 sont situés en amont de l'organe de coupure 12, c'est à dire du côté du réseau électrique 2 par rapport à l'organe de coupure 12.

Le capteur de tension de phase 15 mesure une tension de phase Vp qui est égale à une différence entre le potentiel de la phase 3 et le potentiel du neutre 4 du réseau électrique 2. La tension de phase Vp est ici une tension alternative de fréquence égale 50Hz et de tension efficace égale 230V.

Le capteur de courant de phase 16 mesure un courant de phase Ip qui circule sur le conducteur de phase 13.

La tension de phase Vp et le courant de phase Ip alimentent l'installation électrique 5.

Le compteur 1 comporte en outre une pluralité de composants électriques regroupés en un bloc fonctionnel de métrologie 20 et en un bloc fonctionnel d'application 21. Le bloc fonctionnel de métrologie 20 et le bloc fonctionnel d'application 21 sont séparés et indépendants, de sorte qu'une panne de l'un des blocs n'entraîne pas une panne de l'autre bloc.

Le bloc fonctionnel de métrologie 20 acquiert les mesures de tension de phase Vp et les mesures de courant de phase Ip, et les transmet au bloc fonctionnel d'application 21.

Le bloc fonctionnel d'application 21 comporte des moyens de traitement 22 et une mémoire 23.

Les moyens de traitement 22 comportent un composant de traitement 24 (par exemple un processeur, un microcontrôleur ou un FPGA) adapté à exécuter des instructions d'un programme pour mettre en œuvre le procédé de détection. Le composant de traitement 24 remplit d'autres fonctions, et est notamment adapté à gérer le fonctionnement du compteur 1, à commander l'organe de coupure 12, à traiter les mesures réalisées par le capteur de tension de phase 15 et le capteur de courant de phase 16.

La mémoire 23 est une mémoire non volatile susceptible de stocker des données auxquelles le composant de traitement 24 a accès.

Le procédé de détection consiste tout d'abord à mesurer en amont de l'organe de coupure 12, à intervalles réguliers, la tension de phase Vp et le courant de phase Ip.

Les mesures sont réalisées par le capteur de tension de phase 15 et le capteur de courant de phase 16, puis sont acquises par le bloc fonctionnel de métrologie 20, et sont traitées par le bloc fonctionnel d'application 21.

Les mesures de tension de phase Vp et de courant de phase Ip sont intégrées sur une durée d'intégration. La durée d'intégration est ici égale à 1 minute, mais pourrait être différente, et n'est pas nécessairement constante.

L'intégration permet d'obtenir des valeurs de tension de phase Vp et de courant de phase Ip stabilisées, sans subir les effets des phases transitoires entre deux paliers de courant de phase Ip consommé par l'installation électrique 5.

La durée d'un intervalle régulier correspond à l'échantillonnage normal et habituel utilisé pour mesurer l'énergie électrique consommée par l'installation électrique 5. De même, l'intégration des mesures de tension de phase Vp et de courant de phase Ip est aussi réalisée dans le cadre de la mesure de l'énergie électrique. La mise en oeuvre du procédé de détection ne nécessite donc pas de mesures supplémentaires par rapport aux mesures nécessitées par le fonctionnement habituel du compteur 1.

Le procédé de détection consiste ensuite, lorsque la tension de phase Vp (ici, plus précisément, la valeur efficace de la tension de phase Vp) devient inférieure à un seuil de tension prédéterminé, à ouvrir l'organe de coupure 12.

Le seuil de tension prédéterminé est ici égal à 160V.

Suite à l'ouverture de l'organe de coupure 12, si la tension de phase Vp reprend une valeur de tension normale, le composant de traitement 24 détecte un dysfonctionnement du compteur 1. Le composant de traitement 24 génère alors un message d'alarme à destination du Système d'Information (SI) pour le prévenir du dysfonctionnement du compteur 1. Le composant de traitement 24 maintient ouvert l'organe de coupure 12.

Le message d'alarme est transmis par courants porteurs en ligne ou par tout autre type de moyen de communication (filaire ou sans fil). Dans le cas où des courants porteurs en ligne sont choisis, les couches applicatives DLMS et COSEM sont avantageusement utilisées.

Le message d'alarme est par exemple :
<EventNotificationRequest>
   <AttributeDescriptor>
      <ClassldValue="0001" />
      <InstanceldValue="0000616200FF" />
      <AttributeldValue="02" />
   </AttributeDescriptor>
   <AttributeValue>
      <DoubleLongünsignedValue="00000001" />
   </AttributeValue>
</EventNotificationRequest>

L'encodage associé à l'alarme correspondante est : C20000010000616200FF020600000001.

On note que la communication par courants porteurs en ligne est gérée par un composant de communication alimenté par le réseau électrique 2 depuis un point situé en amont de l'organe de coupure 12, et que les courants porteurs en ligne sont injectés sur le réseau électrique 2 depuis un point situé en amont de l'organe de coupure 12. Ainsi, la transmission du message d'alarme par courants porteurs en ligne est possible même lorsque l'organe de coupure 12 est ouvert.

On note aussi que la détection du dysfonctionnement du compteur 1 permet d'agir de manière préventive contre les possibles conséquences du dysfonctionnement. En l'occurrence, si le dysfonctionnement est un charbonnage de l'organe de coupure 12, ce dysfonctionnement pourrait générer un incendie du compteur 1 voire de l'installation électrique 5.

Suite à l'ouverture de l'organe de coupure 12, si la tension de phase Vp demeure inférieure au seuil de tension prédéterminé, le composant de traitement 24 détecte un affaissement de la tension de phase Vp.

Le composant de traitement 24 génère alors un message d'alerte pour prévenir de l'affaissement de la tension de phase Vp, et referme l'organe de coupure 12.

La valeur de tension normale, évoquée plus tôt, est définie en fonction du courant de phase Ip.

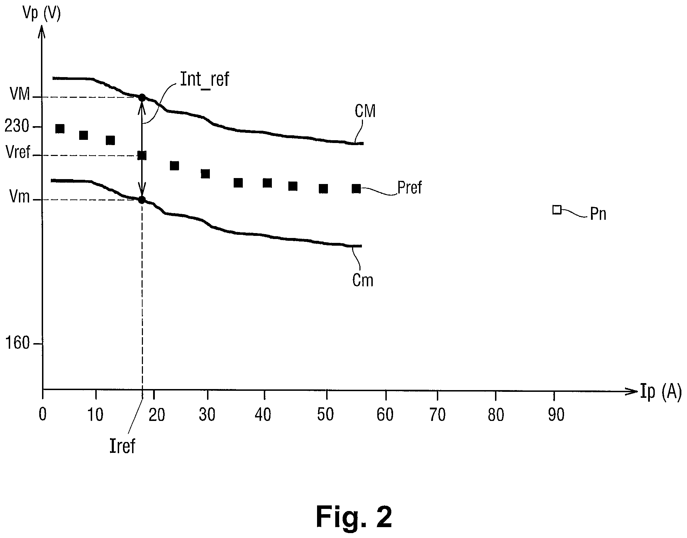

En référence à la figure 2, la valeur de tension normale est comprise dans un intervalle de référence Int ref autour d'une tension de référence Vref. La tension de référence Vref dépend du courant de phase Ip.

On définit ainsi, dans un plan défini par un axe des abscisses et un axe des ordonnées, une pluralité de point de référence Pref. Chaque point de référence Pref a pour abscisse une valeur de courant de référence Iref et pour ordonnée une valeur de tension de référence Vref.

Pour chaque tension de référence Vref, l'intervalle de référence Int_ref a pour borne supérieure une tension maximale VM égale à la valeur de la tension de référence Vref augmentée de 15%, et a pour borne inférieure une tension minimale Vm égale à la valeur de la tension de référence Vref diminuée de 15%.

La courbe CM représente ainsi la tension maximale VM en fonction du courant de phase Ip, alors que la courbe Cm représente la tension minimale Vm en fonction du courant de phase Ip.

Ainsi, pour une valeur de courant de phase Ip égale à un courant de référence Iref, le composant de traitement 24 détermine que la tension de phase Vp reprend une valeur de tension normale si la tension de phase Vp appartient à l'intervalle de référence Int_ref défini par [Vref-15% ; Vref+15%].

Les points de référence Pref sont mémorisés dans une table principale stockée dans la mémoire 23 du bloc fonctionnel d'application 21. La table principale est remplie ici avec une granularité de 1A pour le courant de phase Ip.

Ainsi, suite à l'ouverture de l'organe de coupure 12, pour déterminer si la tension de phase reprend une valeur de tension normale, le composant de traitement 24 accède à la table principale, identifie la valeur de courant de référence Iref de la table principale correspondant au courant de phase Ip mesuré, et utilise la tension de référence Vref de la table principale associée à ladite valeur de courant de référence Iref.

Le procédé de détection comporte en outre une phase d'apprentissage automatique de la tension de référence Vref en fonction du courant de phase Ip. La phase d'apprentissage automatique a pour but de remplir la table principale avec des tensions de phase Vp et des courants de phase Ip réellement mesurés par le compteur 1. Les tensions de phase Vp et les courants de phase Ip qui remplissent la table principale sont mesurés lorsque l'organe de coupure 12 est fermé, en l'absence d'un dysfonctionnement du compteur électrique et d'un affaissement de la tension de phase Vp.

La phase d'apprentissage automatique consiste tout d'abord, pour chaque nouvelle tension de phase Vp et nouveau courant de phase Ip mesurés alors que l'organe de coupure 12 est fermé, à intégrer dans une table secondaire stockée dans la mémoire 23 un nouveau point Pn défini par la nouvelle tension de phase Vp et le nouveau courant de phase Ip.

Ensuite, lorsque le courant de phase Ip prend une valeur d'un courant de référence Iref d'un point de référence Pref (déjà stocké dans la table principale), si la tension de phase Vp correspondante est comprise dans l'intervalle de référence Int_ref autour de la valeur de tension de référence Vref dudit point de référence Pref, le composant de traitement 24 intègre le nouveau point Pn dans la table principale. Le nouveau point Pn, défini par la nouvelle tension de phase Vp et le nouveau courant de phase Ip, devient un point de référence Pref.

La phase d'apprentissage automatique, qui utilise la table secondaire et le concept de « nouveau point », n'est pas immédiatement mise en œuvre à partir de l'installation du compteur 1. Pendant une phase préliminaire de durée prédéterminée, ici égale à une semaine, tous les nouveaux points Pn sont directement intégrés dans la table principale.

On note ici que, au début du procédé de détection, suite à l'ouverture de l'organe de coupure 12, lorsque le composant de traitement 24 tente de déterminer si la tension de phase Vp a repris une valeur de tension normale et tente, pour cela, d'identifier dans la table principale la valeur de courant de référence Iref correspondant au courant de phase Ip mesuré, plusieurs cas peuvent se présenter.

Le cas le plus simple est que la table principale contienne bien une valeur de courant de référence Iref égale au courant de phase Ip (à +/- 1A maximum, du fait de la granularité de 1A de la table principale).

Cependant, il est possible que la table principale ne contienne pas encore une valeur de courant de référence Iref égale au courant de phase Ip (à +/- 1A).

Si la valeur de courant de référence Iref la plus proche diffère du courant de phase Ip, en valeur absolue, d'une valeur inférieure ou égale à un écart de courant prédéterminé, une interpolation linéaire est utilisée pour estimer la tension de référence Vref utilisée.

Par contre, si la valeur de courant de référence Iref la plus proche diffère du courant de phase Ip, en valeur absolue, d'une valeur supérieure à l'écart de courant prédéterminé, le procédé de détection referme l'organe de coupure 12 et le maintient fermé.

L'écart de courant prédéterminé est ici égal à 5A.

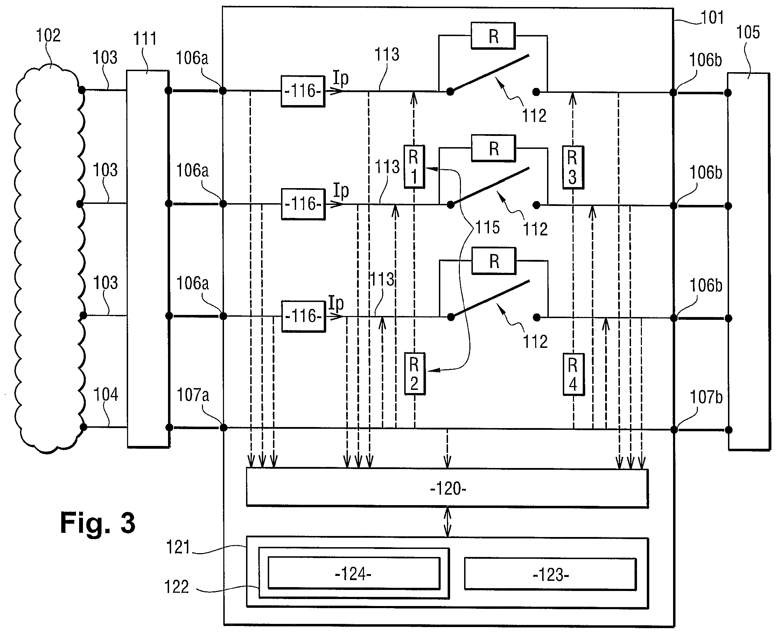

En référence à la figure 3, le procédé de détection d'un affaissement d'une tension de phase d'un réseau électrique selon un deuxième mode de réalisation de l'invention est cette fois mis en oeuvre par un compteur électrique triphasé 101.

Le réseau électrique 102 est un réseau électrique triphasé comprenant trois phases 103 et un neutre 104.

Le compteur 101 est destiné à mesurer une consommation d'énergie électrique fournie par le réseau électrique 102 à une installation électrique 105.

Le compteur 1 comporte trois bornes de phase amont 106a, trois bornes de phase aval 106b, une borne de neutre amont 107a et une borne de neutre aval 107b.

Le compteur 101 comporte de plus trois organes de coupures 112 montés chacun sur le conducteur de phase 113 de l'une des phases 103.

Le compteur 1 comporte de plus des capteurs de tension de phase 115 pour chacune des phases (les trois capteurs de tension de phase 115 sont symbolisés par deux résistances seulement sur la figure 3, pour améliorer la lisibilité de la figure 3), et un capteur de courant de phase 116 pour chacune des phases. Les capteurs de courant de phase 116 sont des tores.

Le compteur 101 comporte à nouveau une pluralité de composants électriques regroupés en un bloc fonctionnel de métrologie 120 et en un bloc fonctionnel d'application 121.

Le bloc fonctionnel d'application 121 comporte des moyens de traitement 122 et une mémoire 123.

Les moyens de traitement 122 comportent un composant de traitement 124.

Le procédé de détection selon le deuxième mode de réalisation consiste à mettre en oeuvre le procédé de détection selon le premier mode de réalisation décrit précédemment pour chacune des phases 103, de manière indépendante.

On utilise donc une table principale par phase et une table secondaire par phase.

Un affaissement de phase est ainsi possiblement détecté pour chaque phase 103, et une phase d'apprentissage automatique est réalisée pour chaque phase 103.

Bien entendu, l'invention n'est pas limitée aux modes de réalisation décrits mais englobe toute variante entrant dans le champ de l'invention telle que définie par les revendications.

Toutes les valeurs numériques fournies ici sont utilisées pour illustrer l'invention, et peuvent bien sûr être différentes lors de la mise en œuvre de l'invention.

L'architecture électrique du compteur monophasé et celle du compteur triphasé peuvent elles aussi être différentes. Les composants utilisés peuvent bien sûr être différents. En particulier, il est possible d'utiliser des capteurs de tension et des capteurs de courant différents.

L'invention s'applique bien sûr à tout compteur polyphasé (et à tout réseau électrique polyphasé).

## Revendications

1. Procédé de détection d'un affaissement d'une tension de phase (Vp) présente sur une phase (3 ; 103) d'un réseau électrique (2 ; 102), le procédé de détection étant mis en oeuvre par un compteur électrique (1 ; 101) qui est connecté au réseau électrique et qui comporte un organe de coupure (12 ; 112) monté sur un conducteur de phase (13 ; 113) relié à la phase (3 ; 103), le procédé de détection comprenant les étapes :
- de mesurer, en amont de l'organe de coupure et à intervalles réguliers, la tension de phase (Vp) et un courant de phase (Ip) circulant sur le conducteur de phase (13) ;
- lorsque la tension de phase devient inférieure à un seuil de tension prédéterminé, d'ouvrir l'organe de coupure ; le procédé étant **caractérisé en ce que**
- suite à l'ouverture de l'organe de coupure, si la tension de phase reprend une valeur de tension normale définie en fonction du courant de phase (Ip), de détecter un dysfonctionnement du compteur électrique, de générer un message d'alarme pour prévenir du dysfonctionnement du compteur électrique, et de maintenir ouvert l'organe de coupure ;
- suite à l'ouverture de l'organe de coupure, si la tension de phase demeure inférieure au seuil de tension prédéterminé, de détecter un affaissement de la tension de phase (Vp), de générer un message d'alerte pour prévenir de l'affaissement de la tension de phase, et de refermer l'organe de coupure (12 ; 112).

2. Procédé de détection selon la revendication 1, dans lequel la valeur de tension normale est comprise dans un intervalle de référence (Int_ref) autour d'une tension de référence (Vref) qui dépend du courant de phase (Ip).

3. Procédé de détection selon la revendication 2, dans lequel la tension de référence (Vref) est issue d'une table principale stockée dans une mémoire (23 ; 123) du compteur électrique, ladite table principale comportant une pluralité de points de référence (Pref) définis chacun par une valeur de tension de référence (Vref) et une valeur de courant de référence (Iref).

4. Procédé de détection selon la revendication 3, comprenant en outre une phase d'apprentissage automatique de la tension de référence (Vref) en fonction du courant de phase (Ip).

5. Procédé de détection selon la revendication 4, dans lequel la phase d'apprentissage automatique comprend les étapes :
- en l'absence d'un dysfonctionnement du compteur électrique et d'un affaissement de la tension de phase (Vp), de mesurer une nouvelle tension de phase et un nouveau courant de phase alors que l'organe de coupure est fermé ;
- d'intégrer dans une table secondaire un nouveau point (Pn) défini par la nouvelle tension de phase et le nouveau courant de phase ;
- ensuite, lorsque le courant de phase (Ip) prend une valeur de courant de référence (Iref) d'un point de référence (Pref), si la tension de phase (Vp) associée est comprise dans l'intervalle de référence autour de la valeur de tension de référence dudit point de référence (Pref), d'intégrer le nouveau point dans la table principale, le nouveau point (Pn) devenant alors un point de référence (Pref).

6. Procédé de détection selon la revendication 5, dans lequel, au cours d'une phase préliminaire de durée prédéterminée, tous les nouveaux points (Pn) sont introduits directement dans la table principale.

7. Procédé de détection d'un affaissement d'au moins une tension de phase d'un réseau électrique polyphasé, consistant à mettre en oeuvre pour chaque phase, de manière indépendante, le procédé de détection selon l'une des revendications précédentes.

8. Procédé de détection selon la revendication 1, dans lequel le dysfonctionnement détecté du compteur électrique est un charbonnage de l'organe de coupure.

9. Compteur électrique comportant un organe de coupure (12 ; 112), un capteur de tension (15 ; 115), un capteur de courant (16 ; 116), et un composant de traitement (24 ; 124) agencé pour mettre en oeuvre le procédé de détection selon l'une des revendications précédentes.

10. Programme d'ordinateur comprenant des instructions pour mettre en oeuvre, par un compteur électrique, le procédé de détection selon l'une des revendications 1 à 8.

11. Moyens de stockage, **caractérisés en ce qu'**ils stockent un programme d'ordinateur comprenant des instructions pour mettre en oeuvre, par un compteur électrique, le procédé de détection selon l'une des revendications 1 à 8.

## Patentansprüche

1. Erkennungsverfahren zum Erkennen eines Abfalls einer Phasenspannung (Vp), die auf einer Phase (3; 103) eines Stromnetzes (2; 102) vorhanden ist, wobei das Erkennungsverfahren von einem Stromzähler (1; 101) durchgeführt wird, der an das Stromnetz angeschlossen ist und der ein Trennorgan (12; 112) umfasst, das auf einem Phasenleiter (13; 113) angebracht ist, der mit der Phase (3; 103) verbunden ist, wobei das Erkennungsverfahren die Schritte umfasst:
- Messen, stromaufwärts des Trennorgans und in regelmäßigen Abständen, der Phasenspannung (Vp) und eines Phasenstroms (Ip), der auf dem Phasenleiter (13) fließt;
- wenn die Phasenspannung niedriger als ein vorbestimmter Spannungsschwellenwert wird, Öffnen des Trennorgans; wobei das Verfahren **dadurch gekennzeichnet ist, dass**
- nach dem Öffnen des Trennorgans, sofern die Phasenspannung wieder einen normalen Spannungswert annimmt, der in Abhängigkeit von dem Phasenstrom (Ip) definiert ist, Erkennen einer Funktionsstörung des Stromzählers, Erzeugen einer Alarmmeldung, um vor einer Funktionsstörung des Stromzählers zu warnen, und Offenhalten des Trennorgans;
- nach dem Öffnen des Trennorgans, sofern die Phasenspannung unter dem vorbestimmten Spannungsschwellenwert bleibt, Erkennen eines Abfalls der Phasenspannung (Vp), Erzeugen einer Alarmmeldung, um vor dem Abfall der Phasenspannung zu warnen, und erneutes Schließen des Trennorgans (12; 112).

2. Erkennungsverfahren nach Anspruch 1, bei dem der normale Spannungswert in einem Referenzintervall (Int_ref) um eine Referenzspannung (Vref) liegt, die von dem Phasenstrom (Ip) abhängt.

3. Erkennungsverfahren nach Anspruch 2, bei dem die Referenzspannung (Vref) aus einer Haupttabelle stammt, die in einem Speicher (23; 123) des Stromzählers gespeichert ist, wobei die genannte Haupttabelle eine Vielzahl von Referenzpunkten (Pref) umfasst, die jeweils durch einen Referenzspannungswert (Vref) und einen Referenzstromwert (Iref) definiert sind.

4. Erkennungsverfahren nach Anspruch 3, ferner umfassend eine automatische Lernphase zum Trainieren der Referenzspannung (Vref) in Abhängigkeit von dem Phasenstrom (Ip).

5. Erkennungsverfahren nach Anspruch 4, bei dem die automatische Lernphase die Schritte umfasst:
- bei Nichtvorliegen einer Funktionsstörung des Stromzählers und eines Abfalls der Phasenspannung (Vp) Messen einer neuen Phasenspannung und eines neuen Phasenstroms, während das Trennorgan geschlossen ist;
- Integrieren eines neuen Punktes (Pn), der durch die neue Phasenspannung und den neuen Phasenstrom definiert ist, in eine sekundäre Tabelle;
- anschließend, wenn der Phasenstrom (Ip) einen Referenzstromwert (Iref) eines Referenzpunktes (Pref) annimmt, sofern die dazugehörige Phasenspannung (Vp) in dem Referenzintervall um den Referenzspannungswert des Referenzpunktes (Pref) liegt, Integrieren des neuen Punktes in die Haupttabelle, wobei der neue Punkt (Pn) dann ein Referenzpunkt (Pref) wird.

6. Erkennungsverfahren nach Anspruch 5, bei dem während einer Vorphase vorbestimmter Dauer alle neuen Punkte (Pn) direkt in die Haupttabelle integriert werden.

7. Erkennungsverfahren zur Erkennung eines Abfalls mindestens einer Phasenspannung eines mehrphasigen Stromnetzes, das darin besteht, das Erkennungsverfahren nach einem der vorhergehenden Ansprüche für jede Phase unabhängig durchzuführen.

8. Erkennungsverfahren nach Anspruch 1, bei dem die erkannte Funktionsstörung des Stromzählers eine Verkohlung des Trennorgans ist.

9. Stromzähler, umfassend ein Trennorgan (12; 112), einen Spannungssensor (15; 115), einen Stromsensor (16; 116) und eine Verarbeitungskomponente (24; 124), die ausgebildet ist, das Erkennungsverfahren nach einem der vorhergehenden Ansprüche durchzuführen.

10. Computerprogramm, umfassend Anweisungen zum Durchführen des Erkennungsverfahrens nach einem der Ansprüche 1 bis 8 durch einen Stromzähler.

11. Speichermittel, die **dadurch gekennzeichnet sind, dass** sie ein Computerprogramm speichern, das Anweisungen zum Durchführen des Erkennungsverfahrens nach einem der Ansprüche 1 bis 8 durch einen Stromzähler umfasst.

## Claims

1. A detection method for detecting a sag of a phase voltage (Vp) present on a phase line (3; 103) of an electricity network (2; 102), the detection method being performed by an electricity meter (1; 101) that is connected to the electricity network and that includes a cut-off member (12; 112) inserted in a phase conductor (13; 113) connected to the phase line (3; 103), the detection method comprising the following steps:
· measuring, upstream from the cut-off member and at regular intervals, the phase voltage (Vp) and a phase current (Ip) conveyed by the phase conductor (13);
· when the phase voltage becomes less than a predetermined voltage threshold, opening the cut-off member; the method being **characterized in that**
· after opening the cut-off member, if the phase voltage returns to a normal voltage value defined as a function of the phase current (Ip), detecting a malfunction of the electricity meter, generating an alarm message to inform about the malfunction of the electricity meter, and keeping the cut-off member open;
· after opening the cut-off member, if the phase voltage remains less than the predetermined voltage threshold, detecting a sag of the phase voltage (Vp), generating a warning message informing about the sag of the phase voltage, and re-closing the cut-off member (12; 112) .

2. A detection method according to claim 1, wherein the normal voltage value lies in a reference interval (Int_ref) about a reference voltage (Vref) that depends on the phase current (Ip).

3. A detection method according to claim 2, wherein the reference voltage (Vref) comes from a main table stored in a memory (23; 123) of the electricity meter, said main table comprising a plurality of reference points (Pref), each defined by a value for the reference voltage (Vref) and by a value for the reference current (Iref) .

4. A detection method according to claim 3, further comprising an automatic training stage for training the reference voltage (Vref) as a function of the phase current (Ip).

5. A detection method according to claim 4, wherein the automatic training stage comprises the following steps:
· in the absence of a malfunction of the electricity meter and in the absence of a sag of the phase voltage (Vp), measuring a new phase voltage and a new phase current while the cut-off member is closed;
· entering a new point (Pn) in a secondary table, the new point (Pn) being defined by the new phase voltage and by the new phase current;
· thereafter, when the phase current (Ip) takes a value for the reference current (Iref) of a reference point (Pref), if the associated phase voltage (Vp) lies in the reference interval about the value of the reference voltage for said reference point (Pref), entering the new point in the main table, the new point (Pn) then becoming a reference point (Pref).

6. A detection method according to claim 5, wherein during a preliminary stage of predetermined duration, all of the new points (Pn) are inserted directly into the main table.

7. A detection method for detecting a sag of at least one phase voltage of a multiphase electricity network, the method consisting in performing the detection method according to any preceding claim, in independent manner for each phase.

8. A detection method according to claim 1, wherein the malfunction of the electricity meter that is detected is blackening of the cut-off member.

9. An electricity meter including a cut-off member (12; 112), a voltage sensor (15; 115), a current sensor (16; 116), and a processor component (24; 124) arranged to perform the detection method according to any preceding claim.

10. A computer program comprising instructions for enabling an electricity meter to perform the detection method according to any one of claims 1 to 8.

11. Storage means **characterized in that** they store a computer program comprising instructions for enabling an electricity meter to perform the detection method according to any one of claims 1 to 8.
